# EUROPÄISCHE PATENTSCHRIFT

(11) **EP 2 347 448 B1**
(45) Veröffentlichungstag und Bekanntmachung des Hinweises auf die Patenterteilung: **10.09.2014**
(21) Anmeldenummer: 09751772.6
(22) Anmeldetag: 10.10.2009
(51) Int. Cl.: H01L 31/18

(54) **VERFAHREN ZUR HERSTELLUNG EINER WAFERBASIERTEN, RÜCKSEITENKONTAKTIERTEN HETERO-SOLARZELLE UND MIT DEM VERFAHREN HERGESTELLTE HETERO-SOLARZELLE**
METHOD FOR PRODUCING A WAFER-BASED, REAR-CONTACTED HETERO SOLAR CELL AND HETERO SOLAR CELL PRODUCED BY THE METHOD
PROCÉDÉ POUR PRODUIRE UNE CELLULE SOLAIRE À HÉTÉROJONCTION SUR PLAQUETTE À MISE EN CONTACT SUR LA FACE ARRIÈRE ET CELLULE SOLAIRE À HÉTÉROJONCTION PRODUITE SELON CE PROCÉDÉ

(30) Priorität: 13.10.2008 DE 102008051521
(43) Veröffentlichungstag der Anmeldung: 27.07.2011
(73) Patentinhaber: Helmholtz-Zentrum Berlin für Materialien und Energie GmbH, 14109 Berlin (DE)
(72) Erfinder: STANGL, Rolf, 12435 Berlin (DE)
(86) Internationale Anmeldenummer: PCT/DE2009/001404
(87) Internationale Veröffentlichungsnummer: WO 2010/043201

(56) Entgegenhaltungen:
- WO-A2-2006/135443
- US-A1- 2006 130 891
- STANGL R ET AL: "Planar rear emitter back contact silicon heterojunction solar cells" SOLAR ENERGY MATERIALS AND SOLAR CELLS ELSEVIER SCIENCE B.V. NETHERLANDS LNKD- DOI:10.1016/J.SOLMAT.2009.06.010, Bd. 93, Nr. 10, Oktober 2009 (2009-10), Seiten 1900-1903, XP002577678 ISSN: 0927-0248
- VAN KERSCHAVER E ET AL: "Back-contact solar cells: a review" PROGRESS IN PHOTOVOLTAICS: RESEARCH AND APPLICATIONS WILEY UK LNKD- DOI:10.1002/PIP.657, Bd. 14, Nr. 2, März 2006 (2006-03), Seiten 107-123, XP002577679 ISSN: 1062-7995

## Beschreibung

Die Erfindung bezieht sich auf ein Verfahren zur Herstellung einer waferbasierten, rückseitenkontaktierten Hetero-Solarzelle mit zumindest einem Absorberwafer und einer rückseitig angeordneten, als Fläche mit punkt- oder streifenförmigen Aussparungen ausgebildeten Emitterschicht aus gegensätzlich dotierten Halbleitermaterialien, wobei die Emitterschicht kontaktiert ist über ein rückseitiges Emitter-Kontaktsystem, das eine Emitter-Kontaktschicht mit zu den Aussparungen in der Emitterschicht kongruenten punkt- oder streifenförmigen Aussparungen aufweist, und der Absorberwafer kontaktiert ist über ein rückseitiges Absorber-Kontaktsystem, das eine Absorber-Kontaktschicht oder -gitter mit Punkt- oder Streifenkontakten, die durch die punkt- oder streifenförmigen Aussparungen der Emitter-Kontaktschicht und der Emitterschicht hindurchgreifen, aufweist, und wobei beide Kontaktsysteme gegeneinander durch eine Isolationsschicht elektrisch isoliert sind.

Solarzellen sind Bauelemente, die Licht in elektrische Energie umwandeln. Üblicherweise bestehen sie aus Halbleitermaterialien, die Bereiche oder Schichten unterschiedlicher Leitfähigkeit für positive und negative Ladungsträger, n-typ oder. p-typ leitende Bereiche, enthalten. Die Bereiche werden als Emitter (Emitterschicht) und Absorber (Absorberschicht, Absorberwafer) bezeichnet. Durch einfallendes Licht erzeugte positive und negative, überschüssige Ladungsträger im Absorber werden am pn-Übergang zwischen Emitter und Absorber getrennt und können durch mit den jeweiligen Emitterund Absorber-Bereichen elektrisch leitend verbundenen Kontaktsystemen gesammelt und abgeführt werden. Die überschüssigen Majoritäts-Ladungsträger aus dem Absorber werden von einem Absorber-Kontaktsystem (Majoritäts-Ladungsträger-Kontaktsystem) und die überschüssigen Minoritäts-Ladungsträger aus dem Absorber werden vom Emitter und von einem, diesen kontaktierenden Emitter-Kontaktsystem (Minoritäts-Ladungsträger-Kontaktsystem) gesammelt und abgeführt. Zur nutzbaren elektrischen Leistung von Solarzellen tragen entsprechend nur solche überschüssigen Ladungsträger bei, die die Kontaktsysteme erreichen und nicht vorher mit einem jeweils gegenpoligen Ladungsträger rekombinieren.

Rückseitig kontaktierte Solarzellen weisen beide Kontaktsysteme zum getrennten Einsammeln der überschüssigen Majoritäts- und Minoritäts-Ladungsträger aus dem Absorberwafer auf der lichtabgewandten Seite der Solarzelle auf. Dies hat zunächst grundsätzlich den Vorteil, dass nur diese Seite des Absorberwafers zur Kontaktierung bearbeitet werden muss, während die andere Seite hinsichtlich der Kontaktierung unbearbeitet bleibt. Ist der Absorberwafer von hinreichend guter elektronischer Qualität, d.h. ist die effektive Diffusionslänge der Minoritäts-Ladungsträger größer als die Waferdicke, so können die stromabführenden Kontaktsysteme auf der lichtabgewandten Rückseite der Solarzelle liegen. Hieraus ergeben sich dann insbesondere die Vorteile, dass erstens keine Abschattungsverluste durch ein vorderseitig angeordnetes Kontaktsystem auftreten, was zu einer Effizienzverbesserung der Solarzelle führt, und zweitens eine gute einfache ganzflächige vorderseitige Passivierung der lichtzugewandten Vorderseite der Solarzelle möglich ist, um hier eine Rekombination der überschüssigen Ladungen effektiv und einfach zu verhindern. Außerdem lassen sich rückseitig kontaktierte Solarzellen einfacher zu Modulen verschalten und besitzen eine hohe Ästhetik.

Allerdings weisen herkömmliche Rückkontakt-Solarzellen mehrere Nachteile auf. Ihre Herstellungsverfahren sind meist aufwändig. Bei manchen Verfahren sind mehrere Maskierungsschritte, mehrere Ätzschritte und/oder mehrere Aufdampfschritte notwendig, um das Absorber-Kontaktsystem elektrisch getrennt vom Emitter-Kontaktsystem an der Rückseite des Wafers auszubilden. Des weiteren leiden herkömmliche Rückkontakt-Solarzellen oft unter lokalen Kurzschlüssen, bedingt z.B. durch Inversionsschichten zwischen Absorber und Emitter oder durch mangelnde Isolierung zwischen den Kontakten, was zu einem reduzierten Wirkungsgrad der Solarzelle führt.

### STAND DER TECHNIK

Ein Konzept der einseitigen Rückseitenkontaktierung stellt die Ausnutzung von Oberflächenerhebungen dar, beispielsweise aus der DE 41 43 083 A1 bekannt. Dabei sind das erste und zweite Kontaktsystem unmittelbar oder auf einer Isolationsschicht auf einer Erhebungen aufweisenden halbleitenden Substratfläche angeordnet, (beispielsweise pyramiden- , kegel- oder zylinderförmig ausgeprägt), wobei die Erhebungen zumindest bereichsweise zuvor mit Passivierungsmaterial abgedeckt und anschließend abschnittsweise zur Anbringung der Kontaktsysteme von diesem freigelegt worden sind. Aus der DE 4143 084 A1 ist es bekannt, zunächst die gesamte strukturierte Substratoberfläche zu passivieren und die Passivierungsschicht anschließend im Bereich der Erhebungen wieder zu entfernen. Aus der DE 101 42 481 A1 ist es bekannt, diese Erhebungen in Form von Rippen auf der Unterseite des aktiven Halbleitersubstrats anzuordnen und je eine Rippenflanke durch gerichtetes Aufdampfen mit einem Kontaktsystem zu versehen. Teil dieses Konzepts ist also immer das Erzeugen von Erhebungen auf der Substratunterseite, die dann in unterschiedlicher Weise bearbeitet werden. Aus der DE 10 2005 040 871 A1 ist eine rückseitig kontaktierte Solarzelle bekannt, bei der sowohl der Emitterkontakt als auch der Absorberkontakt durch Flanken, an denen eine zuvor ganzflächig aufgebrachte Metallisierung durch Ätzen wieder entfernt wurde, elektrisch gegeneinander isoliert sind. Die zu kontaktierenden n- und p-dotierten Bereiche sind entweder interdigitierend nur auf der Waferrückseite oder auf der Wafervorder- und -rückseite angeordnet, wobei der dotierte Bereich auf der Wafervorderseite über Waferkanäle auf die Waferrückseite geführt wird.

Ein anderes Konzept der Rückseitenkontaktierung für waferbasierte System ist die Punktkontaktierung (PC). Hier werden die beiden Kontaktsysteme auf der Rückseite der Solarzelle in Form von Punkten sehr klein gehalten, um den Sättigungssperrstrom zu erniedrigen und damit die Leerlaufspannung der Solarzelle zu erhöhen. Aus der US 5.468.652 ist beispielsweise eine Punktkontaktierung bekannt, bei der die auf der lichtzugewandten Oberseite des Absorberwafers angeordnete Emitterschicht durch Punktkontakte durch den Absorberwafer hindurch mit einem Kontaktsystem auf der Waferrückseite kontaktiert werden. Dabei ist dieses Kontaktsystem mit dem Kontaktsystem zur Ableitung der Majoritäts-Ladungsträger der Absorberschicht nebeneinander verschachtelt angeordnet.

Der Stand der Technik, von dem die vorliegende Erfindung ausgeht, wird in der US 2006/0130891 A1 beschrieben. Offenbart wird eine rückseitenkontaktierte Hetero-Solarzelle mit einem Absorberwafer und einer rückseitig angeordneten, als Fläche mit punkt- oder streifenförmigen Aussparungen ausgebildeten Emitterschicht. Weitere funktionelle Schichten können vorgesehen sein. Absorberwafer und Emitterschicht bestehen aus gegensätzlich dotierten Halbleitermaterialien und spannen einen pn-Übergang auf. Die Emitterschicht wird über ein rückseitiges Emitter-Kontaktsystem kontaktiert, das als Fläche mit punkt- oder streifenförmigen Aussparungen ausgebildet ist. Der Absorberwafer wird über ein rückseitiges Absorber-Kontaktsystem, das eine Absorber-Kontaktschicht oder-gitter mit Punkt- oder Streifenkontakten, die durch die punkt- oder streifenförmigen Aussparungen der Emitter-Kontaktschicht hindurchgreifen, ausgebildet ist, kontaktiert. Beide Kontaktsysteme sind auf der nicht für den Lichteinfall vorgesehenen Rückseite des Absorberwafers übereinander liegend und gegeneinander durch eine Isolationsschicht elektrisch isoliert.

Bei der Herstellung einer solchen Solarzelle wird zunächst ein der Absorberwafer bereitgestellt (Step 1, vergleiche Figur 5 der US 2006/0130891 A1), dann wird - unter Zwischenlage einer Passivierungsschicht - die Emitterschicht ganzflächig auf der Rückseite des Absorberwafers abgeschieden (Step 4), danach wird - unter Zwischenlage einer TCO-Schicht (Step 5) - die Emitter-Kontaktschicht auf der Emitterschicht ganzflächig abgeschieden (Step 6). Bevor die Isolationsschicht ganzflächig aufgebracht wird (Step 8), werden die zuletzt genannten Schichten mit einer Vielzahl von Löchern - bis auf den Absorberwafer herunter - mittels Laser strukturiert (Step 7). Beim Aufbringen der Isolationsschicht werden somit auch die Löcher aufgefüllt. Anschließend wird die Absorberkontaktschicht ganzflächig abgeschieden (Step 9). Durch ein abschließendes Laserfeuern werden die Punktkontakte zwischen der Absorberkontaktschicht und dem Absorberwafer erzeugt (Step 10). Eine besondere Schwierigkeit bei derartig rückseitig kontaktierten Solarzellen ist die aufwändige Herstellung der Rückseitenkontakte gemäß Step 7 und Step 10, bei der elektrische Kurzschlüsse unbedingt vermieden werden müssen. Bei der Erfindung werden daher nur Step 1 (entspricht Verfahrensschritt I), 4 (entspricht Verfahrensschritt IV), 6 (entspricht Verfahrensschritt V), 8 (entspricht Verfahrensschritt VII) und 9 (entspricht Verfahrensschritt IX) durchgeführt, wobei die Kontaktierung der Solarzelle gemäß Verfahrensschritt X ebenfalls als bekannt anzusehen ist, und durch die erfindungsgemäßen Verfahrensschritte II, III, VI und VIII ergänzt.

Außerdem ist es aus der DE 2004 046 554 A1 für eine beidseitig kontaktierte Solarzelle eine punktförmige Rückseitenkontaktierung des Absorberwafers bekannt, bei der eine Schar von Fortsätzen (Peaks) einer Rückkontaktschicht durch eine Oxidationsschicht auf dem Absorberwafer (Lichtstreuschicht) hindurchgreifen bzw. diese nach Laserfeuern durchdringen (Spikebildung). Ferner ist es aus der US 2007/0184975 A1 bekannt, eine große, katalytische wirksame Oberfläche zu erzeugen, indem ein Substrat mit katalytisch aktiven Titandioxid-Nadeln versehen wird.

### AUFGABENSTELLUNG

Ausgehend von dem der Erfindung nächstliegenden Stand der Technik ist die **AUFGABE** für die Erfindung darin zu sehen, ein Verfahren zur Herstellung einer waferbasierten, rückseitenkontaktierten Hetero-Solarzelle der oben erläuterten Art anzugeben, das in einfacher Weise ohne aufwändige Strukturierungsmaßnahmen für die beiden Kontaktsysteme auskommt. Dabei soll jedoch trotzdem eine zuverlässig arbeitende Solarzelle mit einer guten elektrischen Trennung der beiden Kontaktsysteme und einem möglichst hohen Wirkungsgrad zur Verfügung gestellt werden. Die erfindungsgemäße LÖSUNG für diese Aufgabe ist dem Verfahrensanspruch zu entnehmen. Vorteilhafte Modifikationen werden in den Unteransprüchen aufgezeigt und im Folgenden im Zusammenhang mit der Erfindung näher erläutert.

Bei dem erfindungsgemäßen Verfahren zur Herstellung von waferbasierten, rückseitenkontaktierten Hetero-Solarzelle werden zunächst die Punkt- oder Streifenkontakte auf den Absorberwafer aufgebracht und dann anschließend erst der Schichtenaufbau vorgenommen. Dadurch entfallen sämtliche Strukturierungsschritte, insbesondere auch aufwändige lasergestützte Strukturierungsmaßnahmen, sodass geringer auflösende Strukturen einfacher hergestellt werden können. Bei der Erfindung erfolgt die Strukturierung implizit während des Schichtenaufbaus bzw. bei der Entfernung zuvor aufgebrachter Schichten. Bei den bekannten Herstellungsverfahren wird hingegen zunächst der Schichtenaufbau vorgenommen und anschließend gezielte Strukturierungsmaßnahmen, insbesondere Löcher bohren, vorgenommen. Bei der Erfindung hingegen umschließen die flächig aufgebrachten Schichten jeweils die vorab aufgebrachten Kontakte und werden dadurch implizit strukturiert. Zur Vermeidung von Kurzschlüssen und zur Kontaktierung werden entsprechende Schichten auf den Kontakten selektiv entfernt. Dafür weisen die Kontakte Steilflanken auf, die aufgrund ihrer vornehmlich vertikalen Orientierung zum Absorberwafer mit geringeren Schichtdicken bei der Abscheidung der funktionalen Schichten belegt werden. Dabei sollen in vorliegendem Zusammenhang unter dem Begriff "Steilflanken" solche Flanken verstanden werden, die einen Innenwinkel zwischen 20° und 90° mit dem Substrat einschließen. Bei Punkt- oder Streifenkontakten mit einem hohen Aspektverhältnis, d.h. einer geringen Stirnbreite und einer großen Höhe, beispielsweise 1:5 bis 1:10, liegen derartige Steilflanken in der Regel vor. Bei abnehmendem Aspektverhältnis tritt der Winkel der Steilflanken in den Vordergrund. Bei einem sehr geringen Aspektverhältnis, beispielsweise 20:1, was einer eher flächigen Ausdehnung des Kontakts entspricht, sind daher dessen Flanken trotzdem entsprechend steil in dem oben genannten Winkelbereich zu gestalten. Der Fachmann kann also zwischen einem hohen Aspektverhältnis mit grundsätzlich hohe Flankensteilheit und einer hohen Flankensteilheit bei geringerem Aspektverhältnis jede dazwischen liegende Kombination wählen, die zu den geforderten Steilflanken führt, die einen in der Schichtstärke geringeren Auftrag aufweisen als die horizontalen Flächen, södass dieser vor dem Auftrag auf den horizontalen Flächen entfernt sein kann. Bei der Entfernung dieser Schichten, beispielsweise durch Ätzen oder Aufrauen, werden somit die dünneren Schichten auf den Steilflanken zuerst völlig entfernt, sodass bei einem Stoppen des Entfernungsvorgangs zu diesem Zeitpunkt die Schichten auf den horizontalen Flächen noch in ausreichender Schichtstärke vorhanden sind.

Im Einzelnen umfasst das Verfahren, das auch für eine Anwendung bei Dünnschicht-Solarzellen geeignet ist, zumindest folgende Schritte:
I. Bereitstellen des Absorberwafers
II. Abscheiden von metallischen Punkt- oder Streifenkontakten mit Steilflanken auf der für den Lichteinfall nicht vorgesehenen Rückseite des Absorberwafers in vorgegebener Verteilung, wobei die Steilflanken höher sind als die gemeinsame Schichtdicke der zu bildenden Emitterschicht und Emitter-Kontaktschicht,
III. Ummantelung der Punkt- oder Streifenkontakte mit einem Isolationsmantel,
IV. ganzflächiges Abscheiden der Emitterschicht auf der Rückseite des Absorberwafers,
V. ganzflächiges Abscheiden der Emitter-Kontaktschicht auf der Emitterschicht zur Bildung des Emitter-Kontaktsystems,
VI. Freilegen des Isolationsmantels an den Steilflanken der Punkt- oder Streifenkontakte durch selektives Entfernen der Emitter- Kontaktschicht und der Emitterschicht,
VII. ganzflächiges Abscheiden der Isolationsschicht auf der Emitter-Kontaktschicht, wobei am Rand des Absorberwafers ein schmaler Kontaktsteg freigelassen wird,
VIII. Freilegen von Endbereichen der Steilflanken der mit der Isolationsschicht bedeckten Punkt- oder Streifenkontakte,
IX. ganzflächiges Abscheiden der Absorber-Kontaktschicht oder -gitter auf der Isolationsschicht und den freigelegten Endbereichen der Steilflanken der Punkt- oder Streifenkontakte zur Bildung des Absorber-Kontaktsystems und
X. Kontaktieren der Hetero-Solarzelle über den Kontaktsteg des Emitter-Kontaktsystems und die Absorber-Kontaktschicht des Absorber-Kontaktsystems.

Weitere Einzelheiten zu dem erfindungsgemäßen Verfahren und zu vorteilhaften Modifikationen sowie zu der entsprechend herstellbaren, erfindungsgemäßen waferbasierten, rückseitenkontaktierten Hetero-Solarzelle und deren vorteilhafte Modifikationen sind dem speziellen Beschreibungsteil zu entnehmen.

### AUSFÜHRUNGSBEISPIEL

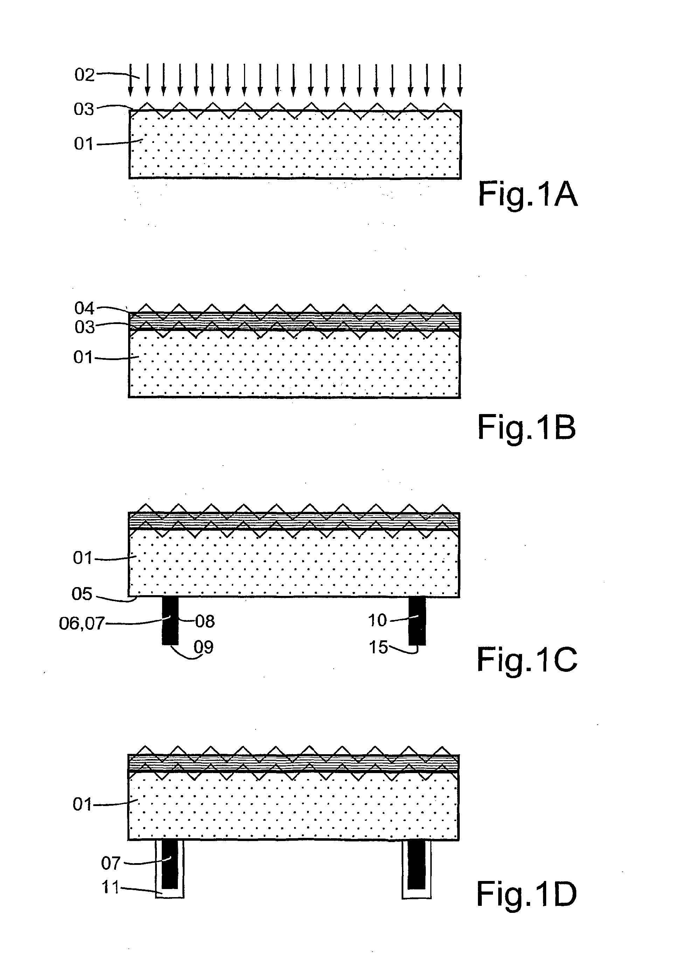

Das Verfahren zur Herstellung einer waferbasierten, rückseitenkontaktierten Hetero-Solarzelle und eine solche Solarzelle selbst nach der Erfindung werden nachfolgend anhand von Ausführungsbeispielen in den schematischen, nicht maßstabsgerechten FIGUREN näher erläutert. Dabei zeigen die
- **FIGUR 1A BIS J**: den schematischen Ablaufplan des Verfahrens mit optionalen zusätzlichen Verfahrensschritten, wobei

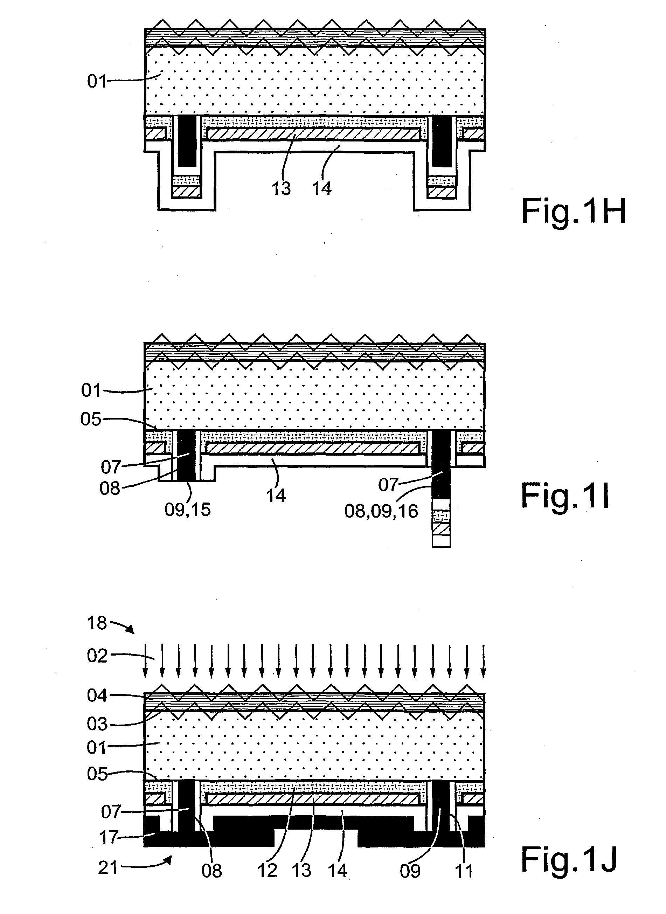

- **FIGUR 1J**: eine fertigprozessierte waferbasierte, rückseitenkontaktierte Hetero-Solarzelle im Querschnitt zeigt.

Bei einzelnen Figuren nicht erwähnte oder gezeigte Bezugszeichen sind den vorangehenden Figuren bzw. deren Beschreibung zu entnehmen.
**FIGUR 1A** **-** Vorderseitige Strukturierung des Absorberwafers Zunächst wird ein Absorberwafer **01**, hier aus kristallinem Silizium, bereitgestellt. Anschließend wird der Absorberwafer **01** auf seiner für den Lichteinfall **02** vorgesehenen Vorderseite **03** strukturiert bzw. texturiert. Im gezeigten Ausführungsbeispiel erfolgt dies durch Erzeugung von Zufallspyramiden durch Ätzen mit Kalilauge KOH.
**FIGUR 1B** **-** Vorderseitige Passivierung/Antireflexbeschichtung Die texturierte Vorderseite **03** des Absorberwafers **01** wird mit einer oder mehreren Passivierungs- und/oder Antireflexschichten **04** versehen. Im gezeigten Ausführungsbeispiel erfolgt dies durch PECVD-Abscheidung von SiO₂/SiN-Schichten.
**FIGUR 1C** **-** Abscheidung von Punkt- oder Streifenkontakten Im gezeigten Ausführungsbeispiel werden auf die nicht für den Lichteinfall vorgesehenen Rückseite **05** des Absorberwafers **01** metallische Abscheidungen **06** abgeschieden. Im gezeigten Ausführungsbeispiel erfolgt dies durch Elektronenstrahlverdampfung von Aluminium über eine Schattenmaske. Alternativ kann auch eine metallische Paste mittels Sieb- oder Tintenstrahldruck aufgebracht werden. Diese punktförmigen Abscheidungen **05** bilden später Punktkontakte **07** von der Absorber-Kontaktschicht zur Rückseite **05** des Absorberwafers **01** aus. Die metallischen Punktkontakte **07** weisen Steilflanken **08** mit Endbereichen **09** auf. Für das nachfolgende selektive Wegätzen ist es erfordertlich, dass die Punktkontakte **07** Steilflanken **08** mit einer großen Flankensteilheit aufweisen, damit nur die entsprechenden Bereiche (horizontal oder vertikal) selektiv weggeätzt werden. Sehr flachen Flanken führen hier nicht zu dem gewünschten Ergebnis. Außerdem müssen die Steilflanken **08** höher sein als die gemeinsame zu bildende Schichtdicke von Emitterschicht **12** und Emitter-Kontaktschicht **13**, damit die Punktkontakte **07** im fertigprozessierten Zustand aus diesen herausragen und kontaktiert werden können.

Die metallischen Abscheidungen **06** können flächig ausgedehnt sein und beispielsweise einen Durchmesser von 100 µm und eine Höhe von 5 µm aufweisen. Ausschlaggebend bei der Gestaltung der metallischen Abscheidungen **06** ist der Flankensteilheit der seitlichen Umrandung aus den oben genannten gründen. Bevorzugt können die Punktkontakte deshalb auch als steile Nadeln **10** (hier dargestellt mit Stirnseiten **15**, alternativ Ausbildung mit Spitzen) ausgebildet werden. Alternativ können auch Streifenkontakte, beispielsweise in der Form von scharfen Schneiden, vorgesehen sein.

Optional kann nach dem Abscheiden der Punktkontakte **07** Kontaktfeuem zur Ausbildung von minoritätsladungsrückstreuenden Feldern (BSF) im Absorberwafer **01** unterhalb der Punktkontakte **07** durchgeführt werden. Dabei erfolgt das Kontaktfeuem in der Regel durch einen schnellen Erhitzungsprozess **(RTP** - Rapid Thermal Process). Kontaktfeuem mithilfe eines Lasers ist ebenfalls möglich.

**FIGUR 1D** **-** Elektrische Isolation der metallischen Punktkontakte

Die rückseitig angeordneten metallischen Punktkontakte **07** werden elektrisch isolierend mit einem Isolationsmantel **11** ummantelt. Im Ausführungsbeispiel geschieht dies durch direktes punkt-strukturiertes Abscheiden einer Isolatorschicht durch Aufbringen einer isolierenden Paste über Sieb- oder Tintenstrahldruck). Alternativ kann auch ein ganzflächiges Abscheiden einer Isolatorschicht, beispielsweise PECVD-Abscheidung von SiO₂, und anschließendes selektives Wegätzen vermittels der Abscheidung einer punktförmigen Maskierungsschicht, beispielsweise über Sieb- oder Tintenstrahldruck. Alternativ kann auch, beispielsweise bei Verwendung von Aluminium als Punktkontakt-Material, eine elektrochemische Oxidation des metallischen Punktkontakts, beispielsweise durch Ausbildung einer isolierenden Al₂O₃-Schicht auf der Oberfläche der Punktkontakte, vorgenommen werden.

### Reinigen der Waferrückseite

Durch selektives Ätzen, beispielsweise HF-Dip, wird nun der Großteil der nicht für den Lichteinfall vorgesehenen Rückseite **05** des Absorberwafers **01**, der nicht von den elektrisch isolierend ummantelten Punktkontakten **07** bedeckt ist, freigelegt. Es werden natürliche Oxide bzw. Verunreinigungen, die durch die vorhergehenden Verfahrensschritte entstanden sind, entfernt, ohne dass hierbei der Isolationsmantel **11** der Punktkontakte **07** entfernt wird.

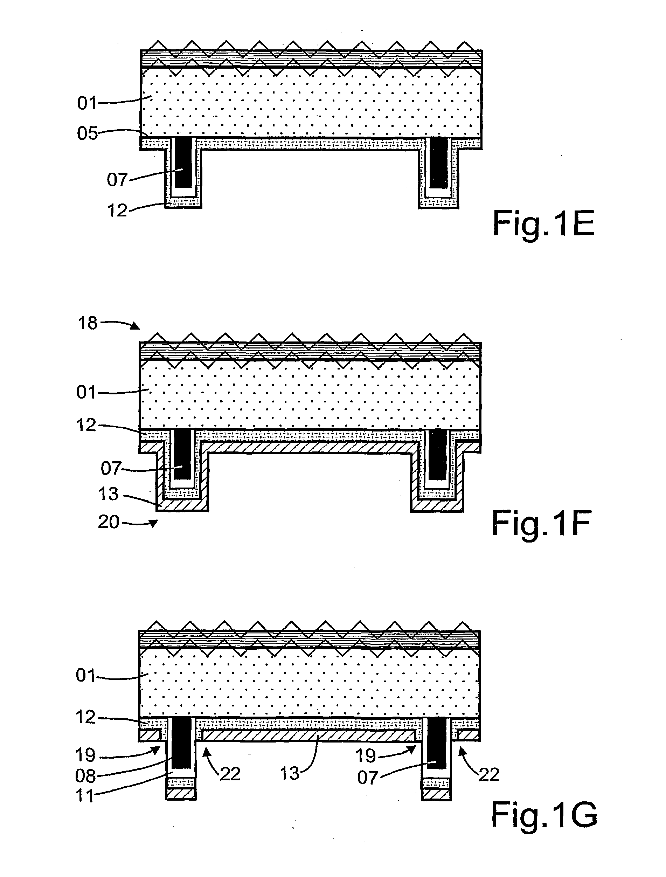

**FIGUR 1E** **-** ganzflächige Abscheidung der rückseitigen Emitterschicht Auf der gesamten Rückseite **05** des Absorberwafers **01** wird dann eine ganzflächige, zum Absorberwafer **01** entgegengesetzt dotierte Emitterschicht **12** (Dünnschicht, beispielsweise aus amorphem Silizium) abgeschieden, im Ausführungsbeispiel durch PECVD-Abscheidung von 30 nm a-Si:H). Die abgeschiedene Emitterschicht **12** muss in der Lage sein, die freigelegte Grenzfläche zum Absorberwafer **01** gut zu passivieren. Die Emitterschicht **12** bedeckt dann sowohl die Oberfläche des Absorberwafers **01** als auch die Oberfläche der elektrisch isolierend ummantelten Punktkontakte **07**.

**FIGUR 1F** **-** ganzflächige Abscheidung der rückseitigen Emitter-Kontaktschicht Auf der rückseitig angeordneten Emitterschicht **12** wird ganzflächig eine metallische Emitter-Kontaktschicht **13** abgeschieden (Schichtdicke beispielsweise 500 nm), im Ausführungsbeispiel mittels Elektronenstrahlverdampfung von Aluminium, alternativ mittels Sieb- oder Tintenstrahldruck von leitfähigen Pasten. Die Emitter-Kontaktschicht **13** bildet das Emitter-Kontaktsystem **20** bei der beanspruchten Hetero-Solarzelle **18**.

**FIGUR 1G** **-** Freilegen der isolierten Steilflanken Die metallische Emitter-Kontaktschicht **13** und die Emitterschicht **12** werden von den seitlichen Steilflanken **08** der isolierend ummantelten Punktkontakte **07** entfernt. Im Ausführungsbeispiel erfolgt dies durch eine zeitlich dosierte Ätzung, da die seitlichen Steilflanken **08** aufgrund der großen Flankensteilheit weniger stark mit der Emitter-Kontaktschicht **13** und der Emitterschicht **12** bedeckt sind als die planare Rückseite **05** des Absorberwafers **01**.

Im Bereich der Punktkontakte **07** entstehen durch das Freilegen der isolierten Steilflanken **08** punktförmige Aussparungen **19** in der Emitterschicht **12** (analog streifenförmige Aussparungen bei Streifenkontakten). Im Bereich der Punktkontakte **07** entstehen punktförmige weitere Aussparungen **22** in der Emitter-Kontaktschicht (analog streifenförmige Aussparungen bei Streifenkontakten), die kongruent zu den Aussparungen **19** in der Emitterschicht **12** liegen.

**FIGUR 1H** **-** ganzflächige Abscheidung der rückseitigen Isolationsschicht Zur elektrischen Isolierung der Emitter-Kontaktschicht **13** gegenüber der Absorber-Kontaktschicht **17** wird auf der Emitter-Kontaktschicht **13** eine Isolationsschicht **14** abgeschieden, im Ausführungsbeispiel mittels PECVD-Abscheidung von 500 nm SiO₂. , Alternativ ist auch Auftragen, Siebdruck, Tintenstrahldruck, Rakeln oder Spin-Coating eines z.B. organischen Harzes oder eines Photolacks möglich.

Für die spätere Kontaktierung der Emitter-Kontaktschicht **13** wird am Rand des Absorberwafers **01** ein schmaler Steg nicht mit der Isolationsschicht **14** bedeckt (in der **FIGUR 1H** nicht dargestellt).

**FIGUR 1I** **-** Freilegen der metallischen Punktkontakte Die Isolationsschicht **14** auf den punktförmigen metallischen Punktkontakten **07** wird im Endbereich **09** der Steilflanken **08** freigelegt. Dabei handelt es sich entweder um Stirnseiten **15** (**FIGUR 1I** links) oder um seitliche Mantelflächen **16** (**FIGUR 1I** rechts) der Steilflanken **08**. Bei Freilegen der Mantelflächen **16** können die freigelegten funktionalen Schichtreste entsprechend entfernt werden. Bei einer Verwendung von Nadeln **10** als Punktkontakte **07** (bzw. Schneiden als Streifenkontakte) entstehen in der Regel keine Stirnseiten **15** bzw. sind diese in ihren Abmessungen so klein, dass die seitlichen Mantelfächen **16** zur Kontaktierung benutzt werden.

Die Freilegung erfolgt im gewählten Ausführungsbeispiel durch mechanisches Aufrauen. Alternativ kann ein selektiver Ätzvorgang durchgeführt werden, der die Steilflanken **08** der ummantelten Punktkontakte **07** angreift, die aufgrund der großen Flankensteilheit der Steilflanken **08** schwächer bedeckt sind als die die planare Rückseite **05** des Absorberwafers **01.**

**FIGUR 1J** **-** ganzflächiges Abscheiden der rückseitigen Absorber-Kontaktschicht Auf die rückseitig angeordnete Isolationsschicht **14** wird nun ganzflächig eine metallische Absorber-Kontaktschicht **17** abgeschieden, im Ausführungsbeispiel mittels Elektronenstrahlverdampfung von Aluminium, alternativ mittels Sieboder Tintenstrahldruck von leitfähigen Pasten. Die Absorber-Kontaktschicht **17** bildet zusammen mit den Punktkontakten **07** das Absorber-Kontaktsystem **21** bei der beanspruchten Hetero-Solarzelle **18**.

### Kontaktieren der fertigprozessierten Hetero-Solarzelle

Die Hetero-Solarzelle 18 wird anschließend über den freigelassenen Steg der rückseitigen Emitter-Kontaktschicht 13 und die rückseitige Absorber-Kontaktschicht 17 kontaktiert.

In der Figur 1J ist eine fertigprozessierte waferbasierte Hetero-Solarzelle 18 mit Rückseitenkontaktierung dargestellt. Bis auf den Absorberwafer 01 sind alle funktionalen Schichten als Dünnschichten aufgebaut. Auf der nicht für den Lichteinfall 02 vorgesehenen Vorderseite 03 des Absorberwafers 01 ist eine Texturierung sowie eine Passivierungs- und/oder Antireflexschicht 04 vorgesehen. Auf der Rückseite 05 des Absorberwafers 01 befinden sich in vorgegebener Verteilung abgeschiedene metallische Punktkontakte 07 (oder Streifenkontakte) mit Steilflanken **08**, die höher als die gemeinsame Schichtdicke von Emitterschicht **12** und Emitter-Kontaktschicht **13** sind. Die Steilflanken **08** sind mit einem Isolationsmantel **11** ummantelt und an ihren Endbereichen **09** mit der Absorber-Kontaktschicht **17** (oder Absorber-Kontaktgitter) bedeckt. Emitter-Kontaktschicht **13** und Absorber-Kontaktschicht **17** sind durch eine Isolationsschicht **14** elektrisch gegeneinander isoliert.

### BEZUGSZEICHENLISTE

- **01**: Absorberwafer
- **02**: Lichteinfall
- **03**: Vorderseite von 01
- **04**: Passivierungs- und/oder Antireflexschicht
- **05**: Rückseite von 01
- **06**: metallische Abscheidung
- **07**: Punktkontakt
- **08**: Steilflanke von 07
- **09**: Endbereich von 07
- **10**: Nadel
- **11**: Isolationsmantel
- **12**: Emitterschicht
- **13**: Emitter- Kontaktschicht
- **14**: Isolationsschicht
- **15**: Stirnseite von 07
- **16**: Mantelfläche von 07
- **17**: Absorber-Kontaktschicht
- **18**: Hetero-Solarzelle
- **19**: punktförmige Aussparung in 12
- **20**: Emitter-Kontaktsystem
- **21**: Absorber-Kontaktsystem
- **22**: punktförmige Aussparung in 13

## Patentansprüche

1. Verfahren zur Herstellung einer waferbasierten, rückseitenkontaktierten Hetero-Solarzelle (18) mit zumindest einem Absorberwafer (01) und einer rückseitig angeordneten, als Fläche mit punkt- oder streifenförmigen Aussparungen (19) ausgebildeten Emitterschicht (12) aus gegensätzlich dotierten Halbleitermaterialien, wobei die Emitterschicht (12) kontaktiert ist über ein rückseitiges Emitter-Kontaktsystem (20), das eine Emitter-Kontaktschicht (13) mit zu den Aussparungen (19) in der Emitterschicht (12) kongruenten punkt- oder streifenförmigen Aussparungen (22) aufweist, und der Absorberwafer (01) kontaktiert ist über ein rückseitiges Absorber-Kontaktsystem (21), das eine Absorber-Kontaktschicht (17) oder-gitter mit Punkt- oder Streifenkontakten (07), die durch die punkt- oder streifenförmigen Aussparungen (19, 22) der Emitter-Kontaktschicht (13) und der Emitterschicht (12) hindurchgreifen, aufweist, und wobei beide Kontaktsysteme (20, 21) gegeneinander durch eine Isolationsschicht (14) elektrisch isoliert sind, mit folgenden Verfahrensschritten:
I. Bereitstellen des Absorberwafers (01),
II. Abscheiden von metallischen Punkt- oder Streifenkontakten (07) mit Steilflanken (08) auf der für den Lichteinfall (02) nicht vorgesehenen Rückseite (05) des Absorberwafers (01) in vorgegebener Verteilung, wobei die Steilflanken (08) höher sind als die gemeinsame Schichtdicke der zu bildenden Emitterschicht (12) und Emitter-Kontaktschicht (13),
III. Ummantelung der Punkt- oder Streifenkontakte (07) mit einem Isolationsmantel (11),
IV. ganzflächiges Abscheiden der Emitterschicht (12) auf der Rückseite (05) des Absorberwafers (01)
V. ganzflächiges Abscheiden der Emitter-Kontaktschicht (13) auf der Emitterschicht (12) zur Bildung des Emitter-Kontaktsystems (20),
VI. Freilegen des Isolationsmantels (11) an den Steilflanken (08) der Punkt-oder Streifenkontakte (07) durch selektives Entfernen der Emitter-Kontaktschicht (13) und der Emitterschicht (12),
VII. ganzflächiges Abscheiden der Isolationsschicht (14) auf der Emitter-Kontaktschicht (13), wobei am Rand des Absorberwafers (01) ein schmaler Kontaktsteg freigelassen wird,
VIII. Freilegen von Endbereichen (09) der Steilflanken (08) der mit der Isolationsschicht (14) bedeckten Punkt- oder Streifenkontakte (07),
IX. ganzflächiges Abscheiden der Absorber-Kontaktschicht (17) oder-gitter auf der Isolationsschicht (14) und der freigelegten Endbereiche (09) der Steilflanken (08) der Punkt- oder Streifenkontakte (07) zur Bildung des Absorber-Kontaktsystems (21) und
X. Kontaktieren der Hetero-Solarzelle (18) über den Kontaktsteg des Emitter-Kontaktsystems (20) und die Absorber-Kontaktschicht (17) des Absorber-Kontaktsystems (21).

2. Verfahren nach Anspruch 1,
**GEKENNZEICHNET DURCH**
Abscheiden von Punktkontakten (07) in Form von Nadeln (10) oder Streifenkontakten in Form von Schneiden.

3. Verfahren nach Anspruch 1,
**GEKENNZEICHNET DURCH** den zusätzlichen Verfahrensschritt
III A. Reinigen der unbedeckten Rückseite (05) des Absorberwafers (01).

4. Verfahren nach Anspruch 3,
**GEKENNZEICHNET DURCH**
Reinigen **durch** selektives Ätzen

5. Verfahren nach Anspruch 1,
**GEKENNZEICHNET DURCH** den zusätzlichen Verfahrensschritt
I A. Strukturieren des Absorberwafers (01) auf der für den Lichteinfall (02) vorgesehenen Vorderseite (03).

6. Verfahren nach Anspruch 5,
**GEKENNZEICHNET DURCH**
Strukturieren **durch** Texturieren des Absorberwafers (01) auf der Vorderseite (03) **durch** Ätzen.

7. Verfahren nach Anspruch 6,
**GEKENNZEICHNET DURCH** den zusätzlichen Verfahrensschritt
I B. Abscheiden von zumindest einer Passivierungs- und/oder Antireflexschicht (04) auf der strukturierten Vorderseite (02) des Absorberwafers (01).

8. Verfahren nach Anspruch 7,
**GEKENNZEICHNET DURCH**
PECVD-Abscheiden von SiO₂/SiN-Schichten als Passivierungs- und/oder Antireflexschichten (04).

9. Verfahren nach Anspruch 1,
**GEKENNZEICHNET DURCH** den zusätzlichen Verfahrensschritt
II A. Kontaktfeuerung zur Ausbildung von lokalen Feldpassivierungsbereichen unterhalb der Punkt- oder Streifenkontakte (07).

10. Verfahren nach Anspruch 1,
**GEKENNZEICHNET DURCH**
Ummanteln der Punkt- oder Streifenkontakte (07) mit einem Isolationsmantel (11) **durch**
• Sieb- oder Tintenstrahldruck mit einer isolierenden Paste oder
• ganzflächiges Abscheiden einer isolierenden Schicht und anschließend selektives Ätzen **durch** eine punkt- oder streifenförmige, mittels Sieb-oder Tintenstrahldruck aufgebrachte Maskierungsschicht oder
• elektrochemische Oxidation, wobei die Punkt- oder Streifenkontakte dabei aus oxidierbarem Material bestehen.

11. Verfahren nach Anspruch 1,
**GEKENNZEICHNET DURCH**
ganzflächiges Abscheiden der Emitter-Kontaktschicht (13) **durch** Metall-Elektronenstrahlverdampfung oder **durch** Siebdruck metallischer Pasten.

12. Verfahren nach Anspruch 1,
**GEKENNZEICHNET DURCH**
im Verfahrensschritt VI: Freilegen des Isolationsmantels (11) an den Steilflanken (08) der Punkt- oder Streifenkontakte (07) **durch** zeitlich eingestelltes Ätzen.

13. Verfahren nach Anspruch 1,
**GEKENNZEICHNET DURCH**
ganzflächiges Abscheiden der Isolationsschicht (14) **durch**
• PECVD-Abscheidung oder
• Auftragen oder Rakeln oder
• Sieb- oder Tintenstrahldruck oder
• Spin-Coating eines organischen Harzes oder Photolacks.

14. Verfahren nach Anspruch 1,
**GEKENNZEICHNET DURCH**
im Verfahrensschritt VIII: Freilegen von Endbereichen (09) der Steilflanken (08) der Punkt- oder Streifenkontakte (07) **durch**
• mechanisches Aufrauen oder
• selektives Ätzen.

15. Verfahren nach Anspruch 1,
**GEKENNZEICHNET DURCH**
ganzflächiges Abscheiden der Absorber-Kontaktschicht (17) **durch**
• Metall-Elektronenstrahlverdampfung oder
• Siebdruck metallischer Pasten.

## Claims

1. A method for the manufacture of a wafer-based hetero-junction solar cell (18) with contacts on its rear face, and with at least one absorber wafer (01) and an emitter layer (12) of oppositely doped semi-conductor materials arranged on the rear face, designed as a surface with point-form or strip-form openings (19), wherein contact with the emitter layer (12) is established via a rear face emitter contact system (20), which has an emitter contact layer (13) with point-form or strip-form openings (22) that are congruent with the openings (19) in the emitter layer (12), and contact with the absorber wafer (01) is established via a rear face absorber contact system (21), which has an absorber contact layer (17) or lattice with point contacts or strip contacts (07) that pass through the point-form or strip-form openings (19, 22) of the emitter contact layer (13) and the emitter layer (12), and wherein both contact systems (20, 21) are electrically insulated from one another by means of an insulation layer (14), with the following method steps:
I. Preparation of the absorber wafer (01),
II. Deposition in a prescribed distribution of metallic point contacts or strip contacts (07) with steep flanks (08) on the rear face (05) of the absorber wafer (01) not provided for the incidence of light (02), wherein the steep flanks (08) are taller than the total thickness of the emitter layer (12) and emitter contact layer (13) to be formed,
III. Encasement of the point contacts or strip contacts (07) in an insulation jacket (11),
IV. Whole surface deposition of the emitter layer (12) on the rear face (05) of the absorber wafer (01)
V. Whole surface deposition of the emitter contact layer (13) on the emitter layer (12) to form the emitter contact system (20),
VI. Exposure of the insulation jacket (11) on the steep flanks (08) of the point contacts or strip contacts (07) by selective removal of the emitter contact layer (13) and the emitter layer (12),
VII. Whole surface deposition of the insulation layer (14) on the emitter contact layer (13), wherein at the edge of the absorber wafer (01) a narrow contact web is left exposed,
VIII. Exposure of end regions (09) of the steep flanks (08) of the point contacts or strip contacts (07) covered with the insulation layer (14),
IX. Whole surface deposition of the absorber contact layer (17) or lattice on the insulation layer (14) and the exposed end regions (09) of the steep flanks (08) of the point contacts or strip contacts (07) to form the absorber-contact system (21), and
X. Establishment of contacts with the hetero-junction solar cell (18) via the contact web of the emitter contact system (20) and the absorber contact layer (17) of the absorber contact system (21).

2. The method in accordance with Claim 1, **characterised by** deposition of point contacts (07) in the form of needles (10) or strip contacts in the form of blades.

3. The method in accordance with Claim 1, **characterised by** the additional method step
III A. Cleaning of the uncovered rear face (05) of the absorber wafer (01).

4. The method in accordance with Claim 3, **characterised by** cleaning by means of selective etching.

5. The method in accordance with Claim 1, **characterised by** the additional method step:
IA. structuring of the absorber wafer (01) on the front face (03) provided for the incidence of light (02).

6. The method in accordance with Claim 5, **characterised by** structuring by texturing the absorber wafer (01) on the front face (03) by means of etching.

7. The method in accordance with Claim 6, **characterised by** the additional method step:
I B. Deposition of at least one passivation layer and/or anti-reflex layer (04) on the structured front face (02) of the absorber wafer (01).

8. The method in accordance with Claim 7, **characterised by** PECVD-deposition of Si0₂/SiN-layers as passivation layers and/or anti-reflex layers (04).

9. The method in accordance with Claim 1, **characterised by** the additional method step:
II A. Contact firing to form local field passivation regions underneath the point contacts or strip contacts (07).

10. The method in accordance with Claim 1, **characterised by**
• Encasement of the point contacts or strip contacts (07) with an insulation jacket (11) by means of
• Screen printing or ink jet printing with an insulating paste, or
• Whole surface deposition of an insulating layer and subsequently selective etching by means of a point-form or strip-form masking layer applied by means of screen printing or ink jet printing, or
• Electrochemical oxidation, wherein the point contacts or strip contacts here consist of an oxidisable material.

11. The method in accordance with Claim 1, **characterised by** whole surface deposition of the emitter contact layer (13) by means of electron beam vaporisation of metal, or by means of the screen printing of metallic pastes.

12. The method in accordance with Claim 1, **characterised by** in the method step VI:
Exposure of the insulation jacket (11) on the steep flanks (08) of the point contacts or strip contacts (07) by means of etching adjusted in terms of time.

13. The method in accordance with Claim 1, **characterised by** whole surface deposition of the insulation layer (14) by means of
• PECVD deposition, or
• Application by spreading or the use of squeegees, or
• Screen printing or ink jet printing, or
• Spin-coating of an organic resin or photoresist.

14. The method in accordance with Claim 1, **characterised by** in the method step VIII:
Exposure of end regions (09) of the steep flanks (08) of the point contacts or strip contacts (07) by means of
• Mechanical grinding, or
• Selective etching.

15. The method in accordance with Claim 1, **characterised by** whole surface deposition of the absorber-contact layer (17) by means of
• Electron beam vaporisation of metal, or
• Screen printing of metallic pastes.

## Revendications

1. Procédé pour la fabrication d'une cellule solaire hétérogène (18), à base d'une plaquette, à contact sur la face arrière, avec au moins une plaquette d'absorbeur (01) et une couche d'émission (12), disposée sur la face arrière, réalisée en tant que surface avec des évidements (19) en forme de points ou de bandes en matériaux semi-conducteurs dopés de manière antagoniste, la couche d'émission (12) étant mise en contact par l'intermédiaire d'un système de contact d'émission (20) de face arrière, lequel présente une couche de contact d'émission (13) avec des évidements (22) en forme de points ou de bandes congruents par rapport aux évidements (19) dans la couche d'émission (12), et la plaquette d'absorbeur (01) étant mise en contact par l'intermédiaire d'un système de contact d'absorbeur (21) de face arrière, lequel présente une couche de contact d'absorbeur (17) ou grille avec des contacts en forme de points ou de bandes (07) qui traversent les évidements en forme de points ou de bandes (19, 22) de la couche de contact d'émission (13) et de la couche d'émission (12), et les deux systèmes de contact (20, 21) étant isolés électriquement l'un par rapport à l'autre grâce à une couche d'isolation (14), avec les étapes suivantes du procédé :
I. mise à disposition de la plaquette d'absorbeur (01),
II. dépôt de contacts métalliques en forme de points ou bandes (07) avec des flancs raides (08) sur la face arrière (05) non prévue pour l'incidence de la lumière (02) de la plaquette d'absorbeur (01) selon une répartition prédéfinie, les flancs raides (08) étant plus élevés que l'épaisseur de couche commune de la couche d'émission (12) et de la couche de contact d'émission (13) à former,
III. enveloppement des contacts en forme de points ou de bandes (07) avec une enveloppe d'isolation (11),
IV. dépôt, sur toute la surface, de la couche d'émission (12) sur la face arrière (05) de la plaquette d'absorbeur (01),
V. dépôt, sur toute la surface, de la couche de contact d'émission (13) sur la couche d'émission (12) pour la formation du système de contact d'émission (20),
VI. mise à nu de l'enveloppe isolante (11) au niveau des flancs raides (08) des contacts en forme de points ou bandes (07) par élimination sélective de la couche de contact d'émission (13) et de la couche d'émission (12),
VII. dépôt, sur toute la surface, de la couche d'isolation (14) sur la couche de contact d'émission (13), une mince nervure de contact étant laissée dégagée sur le bord de la plaquette d'absorbeur (01),
VIII. mise à nu de zones d'extrémité (09) des flancs raides (08) des contacts en forme de points ou bandes (07) recouverts par la couche d'isolation (14),
IX. dépôt, sur toute la surface, de la couche de contact d'absorbeur (17) ou grille sur la couche d'isolation (14) et les zones d'extrémité (09) mises à nu des flancs raides (08) des contacts en forme de points ou bandes (07) pour la formation du système de contact d'absorbeur (21) et
X. mise en contact de la cellule solaire hétérogène (18) via la nervure de contact du système de contact d'émission (20) et la couche de contact d'absorbeur (17) du système de contact d'absorbeur (21).

2. Procédé selon la revendication 1, **caractérisé par** le dépôt de contacts punctiformes (07) sous la forme d'aiguilles (10) ou de contacts en bande sous la forme de lames.

3. Procédé selon la revendication 1, **caractérisé par** l'étape supplémentaire du procédé III A. consistant à nettoyer la face arrière (05) non recouverte de la plaquette d'absorbeur (01).

4. Procédé selon la revendication 3, **caractérisé par** le nettoyage grâce à un décapage sélectif.

5. Procédé selon la revendication 1, **caractérisé par** l'étape supplémentaire du procédé I A. consistant à structurer la plaquette d'absorbeur (01) sur la face avant (03) prévue pour l'incidence de la lumière (02).

6. Procédé selon la revendication 5, **caractérisé par** une structuration par texturation de la plaquette d'absorbeur (01) sur la face avant (03) grâce à une gravure.

7. Procédé selon la revendication 6, **caractérisé par** l'étape supplémentaire du procédé I B. consistant à déposer au moins une couche de passivation et/ou antireflet (04) sur la face avant (02) structurée de la plaquette d'absorbeur (01).

8. Procédé selon la revendication 7, **caractérisé par** un dépôt PECVD de couches de SiO₂/SiN en tant que couches de passivation et/ou antireflet (04).

9. Procédé selon la revendication 1, **caractérisé par** l'étape supplémentaire du procédé II A. de brûlure des contacts pour la formation de zones de passivation de champ locales en dessous des contacts en forme de points ou de bandes (07).

10. Procédé selon la revendication 1, **caractérisé par** l'enveloppement des contacts en forme de points ou de bandes (07) avec une enveloppe isolante (11) grâce à
- une impression par sérigraphie ou jet d'encre avec une pâte isolante, ou
- un dépôt, sur toute la surface, d'une couche isolante et une gravure sélective qui s'en suit grâce à une couche de masquage en forme de point ou de bande appliquée à l'aide d'une impression par sérigraphie ou jet d'encre, ou
- une oxydation électrochimique, les contacts en forme de points ou de bandes se composant dans ce cas d'un matériau pouvant s'oxyder.

11. Procédé selon la revendication 1, **caractérisé par** un dépôt, sur toute la surface, de la couche de contact d'émission (13) grâce à une évaporation métallique par faisceau d'électrons ou grâce à une impression par sérigraphie de pâtes métalliques.

12. Procédé selon la revendication 1, **caractérisé par**, lors de l'étape VI du procédé : mise à nu de l'enveloppe d'isolation (11) au niveau des flancs raides (08) des contacts en forme de points ou de bandes (07) grâce à une gravure réglée dans le temps.

13. Procédé selon la revendication 1, **caractérisé par** un dépôt, sur toute la surface, de la couche d'isolation (14) grâce à
- un dépôt PECVD, ou
- une application ou enduction à la racle, ou
- une impression par sérigraphie ou jet d'encre, ou
- une enduction par centrifugation d'une résine organique ou d'un agent de photoréserve.

14. Procédé selon la revendication 1, **caractérisé par**, lors de l'étape VII du procédé : mise à nu de zones d'extrémité (09) des flancs raides (08) des contacts en forme de points ou de bandes (07) grâce à
- un grattage mécanique ou
- une gravure sélective.

15. Procédé selon la revendication 1, **caractérisé par** un dépôt, sur toute la surface, de la couche de contact d'absorbeur (17) grâce à
- une évaporation métallique par faisceau d'électrons ou
- une impression par sérigraphie de pâtes métalliques.
